# DEMANDE DE BREVET EUROPEEN

(11) **EP 4 757 504 A1**
(43) Date de publication de la demande: **10.06.2026**
(21) Numéro de dépôt: 25315371.2
(22) Date de dépôt: 22.10.2025
(51) Int. Cl.: H05K 1/02, H05K 1/11, H05K 1/181, H05K 3/341

(54) **BOITIER DE PUCE ELECTRONIQUE**

(30) Priorité: 09.12.2024 EP 24315564
(71) Demandeur: STMicroelectronics International N.V., 1228 Plan-les-Ouates, Geneva (CH)
(72) Inventeur: Knopik, Vincent, 38830 CRETS EN BELLEDONNE (FR); Didion, Julien, 38000 GRENOBLE (FR)
(74) Mandataire: Cabinet Beaumont

(57) **Abrégé**

La présente description concerne un boitier (100) de puce électronique comprenant :
- au moins une première borne (103) adaptée à recevoir et/ou à fournir un potentiel d'alimentation ;
- au moins une deuxième borne (102) adaptée à recevoir et/ou à fournir un potentiel de référence ; et
- au moins une troisième borne (104) adaptée à recevoir et/ou à fournir un signal de données,
dans lequel ladite au moins une troisième borne est disposée en périphérie, et ladite au moins une première borne est disposée plus au centre que ladite au moins une troisième borne.

## Description

### Domaine technique

La présente description concerne de façon générale les systèmes et dispositifs électroniques, et, en particulier, la protection et l'intégration de ces systèmes et dispositifs électroniques par des boitiers.

### Technique antérieure

Les boitiers utilisés pour protéger et connecter les systèmes et dispositifs électroniques, et par exemple des puces électroniques, ont sans cesse besoin d'être améliorés pour répondre à des nouveaux besoins. Un enjeu majeur avec la constante évolution de l'électronique est la taille des boitiers. Il existe, en effet, un besoin pour des boitiers de puce électronique de plus en plus petits.

Il serait souhaitable de pouvoir améliorer, au moins en partie, certains aspects des boitiers connus de dispositifs électroniques.

### Résumé de l'invention

Il existe un besoin pour des dispositifs électroniques moins encombrants, et, en particulier, 'des boitiers de dispositifs électroniques moins encombrants.

Il existe un besoin pour des dispositifs électroniques traitant des signaux radiofréquences moins encombrants, et, en particulier, des boitiers pour de tels dispositifs électroniques moins encombrants.

Un mode de réalisation pallie tout ou partie des inconvénients des boitiers connus de dispositifs électroniques.

Un mode de réalisation prévoit un boitier de puce électronique comprenant :
- au moins une première borne adaptée à recevoir et/ou à fournir un potentiel d'alimentation ;
- au moins une deuxième borne adaptée à recevoir et/ou à fournir un potentiel de référence ; et
- au moins une troisième borne adaptée à recevoir et/ou à fournir un signal de données,
dans lequel ladite au moins une troisième borne est disposée en périphérie, et ladite au moins une première borne est disposée plus au centre que ladite au moins une troisième borne.

Un autre mode de réalisation prévoit un procédé de fabrication d'un boitier de puce électronique comprenant :
- au moins une première borne adaptée à recevoir et/ou à fournir un potentiel d'alimentation ;
- au moins une deuxième borne adaptée à recevoir et/ou à fournir un potentiel de référence ; et
- au moins une troisième borne adaptée à recevoir et/ou à fournir un signal de données,
dans lequel ladite au moins une troisième borne est disposée en périphérie, et ladite au moins une première borne est disposée plus au centre que ladite au moins une troisième borne.

Selon un mode de réalisation, au moins une deuxième borne ou au moins une troisième borne est présente entre la ou chaque première borne et la périphérie du boîtier.

Selon un mode de réalisation, au moins une deuxième borne est présente entre une première borne et une troisième borne dans au moins une direction.

Selon un mode de réalisation, ledit boîtier comporte au moins deux deuxièmes bornes, la ou chaque première borne étant disposées entre deux deuxièmes bornes dans au moins une direction.

Selon un mode de réalisation, ledit boitier comprend plusieurs troisièmes bornes disposées en périphérie de la ou des deuxièmes bornes.

Selon un mode de réalisation, la ou les premières bornes sont entourées par des deuxièmes bornes.

Selon un mode de réalisation, le boitier comprend, en outre, au moins une quatrième borne adaptée à recevoir et/ou à fournir un signal de commande basé sur des tensions continues.

Selon un mode de réalisation, la ou au moins une des troisièmes bornes est adaptée à recevoir et/ou à fournir un signal radiofréquence.

Selon un mode de réalisation, ledit potentiel d'alimentation est différent du potentiel de référence.

Selon un mode de réalisation, ledit potentiel de référence est la masse.

Selon un mode de réalisation, la ou les deuxièmes bornes sont reliées à un plan de masse, et la ou les première bornes sont reliées à un niveau de métallisation par un via traversant ledit plan de masse.

Un autre mode de réalisation prévoit une puce électronique comprenant un boitier décrit précédemment.

Selon un mode de réalisation, la puce comprend, en outre, au moins un composant électronique.

Un autre mode de réalisation prévoit un procédé d'utilisation d'un boitier décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, schématiquement, un mode de réalisation d'un boitier de dispositif électronique ;
la figure 2 représente une vue en coupe d'une partie du mode de réalisation de la figure 1 ;
la figure 3 représente, schématiquement, des exemples de réalisation du mode de réalisation de la figure 1 ; et
la figure 4 représente, schématiquement, d'autres exemples de réalisation du mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur »,. « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

On appelle ici des signaux radiofréquence, des signaux ayant des fréquences comprises entre quelques hertz et plus de 300 GHz, par exemple comprises entre 3 kHz et 300 GHz.

Dans le domaine de la radiofréquence, les phénomènes de couplages électromagnétiques apparaissent entre deux conducteurs transmettant des signaux de même fréquence et qui proches l'un de l'autre, et ce sans même être en contact. Ces phénomènes deviennent une source de contrainte lors la réduction des dimensions des dispositifs utilisant des signaux du domaine des radio fréquence.

Les modes de réalisation décrits ci-après concernent un boitier destiné à protéger et connecter un système ou dispositif électronique représenté sous forme d'une puce électronique, et son procédé de fabrication. Il est nécessaire de rendre de tels boitiers de plus en plus petits. Cependant, lorsque la puce est adaptée à traiter des signaux de données, comme par exemple des signaux hautes fréquences ou des signaux radiofréquence, certaines contraintes de placement de bornes de connexion empêchent de réduire la taille du boitier. La solution apportée par ces modes de réalisation est la suivante. Il convient de disposer une ou plusieurs bornes adaptées à recevoir et/ou à fournir un potentiel d'alimentation au milieu du plan de masse du boitier, c'est-à-dire entre au moins deux bornes adaptées à recevoir et/ou à fournir un potentiel de référence, par exemple la masse. Les autres bornes de la puce sont alors placées en périphérie du plan de masse, c'est-à-dire en périphérie desdites au moins deux bornes adaptées à recevoir et/ou à fournir le potentiel de référence. Selon un exemple, le potentiel d'alimentation est différent du potentiel de référence, par exemple supérieur ou inférieur. Ces autres bornes sont, par exemple, des bornes adaptées à recevoir et/ou à fournir un ou plusieurs signaux de données, comme des signaux hautes fréquences ou des signaux radiofréquence, et/ou des bornes adaptées à recevoir et/ou à fournir un ou plusieurs signaux de commande basés sur des tensions continues.

Un avantage d'une telle disposition des bornes de connexion du boitier est de réduire la taille effective du boitier.

Les modes de réalisation décrits ci-après concernent, en outre, un procédé de fabrication, un procédé d'utilisation d'un tel boitier, mais aussi une puce électronique comprenant un tel boitier. Une telle puce utilise un boitier selon un mode de réalisation pour protéger le ou les composants ou le ou les circuits qu'elle comprend.

De plus, les modes de réalisation décrits ci-après sont tout particulièrement adaptés à être utilisés dans toute sorte -d'industrie, et en particulier dans l'industrie des circuits d'interface avec des antennes.

De plus, les modes de réalisation décrits ci-dessus sont particulièrement adaptés pour être utilisés dans tout type de marchés industriels où une puce électronique protégée par un boitier est susceptible d'être utilisée. Plus particulièrement, une telle puce peut être destiné à :
- l'industrie automobile, par exemple dans le domaine de l'électrification automobile ou dans le domaine des systèmes avancés d'aide à la conduite (Advanced Driver Assistance Systems - ADAS) ;
- le secteur industriel, par exemple dans le domaine de l'énergie verte, dans le domaine de l'électrification des infrastructures, de l'internet des objets (Internet of Things - IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

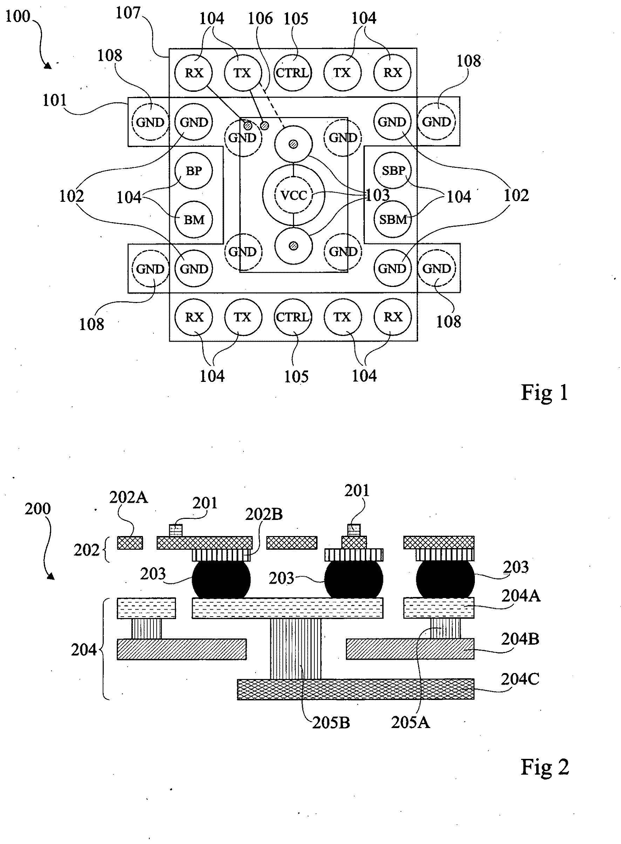

La figure 1 représente, très schématiquement, une vue de dessus d'un mode de réalisation d'un boitier 100 d'un dispositif électronique ou d'une puce électronique. Plus particulièrement, la figure 1 représente la disposition des différentes bornes de connexion du boitier 100.

Le boitier 100 est un boitier de dispositif ou puce électronique adapté à recouvrir les faces d'un dispositif ou d'une puce électronique pour les protéger contre l'environnement extérieur, tout en rendant accessible les différentes connexions de ce dispositif ou cette puce électronique. Si le dispositif électronique à protéger est formé à partir d'une carte de circuit imprimé, le boitier peut recouvrir une partie ou la totalité de cette carte de circuit imprimé. En figure 1, le boitier 100 est délimité par une forme 107 rectangulaire. La carte de circuit imprimé sur laquelle est formé le dispositif électronique comprend une couche conductrice formant un plan de masse 101, c'est-à-dire un plan recevant et fournissant un potentiel de référence, par exemple la masse. Le plan de masse 101 peut être de formes diverses en fonction des besoins du dispositif ou de la puce électronique. Dans le cas de la figure 1, le plan de masse 101 est en forme de "H" couché.

Selon un mode de réalisation, le boitier comprend :
- au moins une borne 102 (GND), préférentiellement deux bornes pour des raisons de symétrie, adaptées à recevoir et/ou à fournir un potentiel de référence ;
- au moins une borne 103 (VCC) adaptée à recevoir et/ou à fournir un potentiel d'alimentation ;
- au moins une borne 104 (RF) adaptée à recevoir et/ou à fournir un signal de donnée radio fréquence ; et
- de façon optionnelle, au moins une borne 105 (CTRL) adaptée à recevoir et/ou à fournir un signal de commande basé sur des tensions continues.

Selon un mode de réalisation, les bornes 102, aussi appelées bornes de référence 102, sont reliées, de préférence connectées, au plan de masse 101. Selon un exemple, les bornes 102 sont, pour cela, disposées directement au-dessus du plan de masse 101. Des bornes 108 (GND) du plan de masse 101 sont représentées en pointillés, ce sont des bornes du plan de masse qui ne sont pas reprises par le boitier 100.

Selon un mode de réalisation, les bornes 103, aussi appelées bornes d'alimentation 103, sont disposées au niveau du plan de masse 101, et sont plus particulièrement entourées par le plan de masse 101. Plus particulièrement, dans l'exemple représenté, des bornes de référence sont reparties autour des bornes 103. Dit autrement, chaque borne 103 est, dans au moins une direction, disposée entre deux bornes de référence 102. Selon un mode de réalisation, le potentiel d'alimentation des bornes 103 est différent du potentiel de référence, par exemple supérieur au potentiel de référence. Selon un exemple, Chaque borne 103 est reliée à une piste conductrice du boitier 100 par un via traversant le plan de masse 101. Cela est détaillé en relation avec la figure 2.

Il est courant de former le boitier 100 dans lequel les bornes de connexion sont disposées suivant un ou plusieurs axes de symétrie, de façon à rendre homogène les trajets des signaux reçus et/ou émis par le dispositif ou la puce électronique. Selon un exemple, la ou les bornes d'alimentation 103 sont disposées sur des axes de symétrie du boitier 100. Selon un exemple, si le boitier 100 comprend plusieurs axes de symétrie, la ou les bornes d'alimentation 103 sont disposées à l'intersection des axes de symétrie du boitier 100.

Selon un mode de réalisation, la ou les bornes 104 sont des bornes adaptées à recevoir et/ou à fournir des signaux de données. Selon un mode de réalisation, ces signaux de données sont des signaux périodiques, comme par exemple des signaux haute fréquence, tels que des signaux radiofréquence, ou signaux RF. On appelle signal radiofréquence, un signal ayant des fréquences comprises entre quelques hertz et plus de 300 GHz, par exemple comprises entre 3 kHz et 300 GHz. Pour éviter des problèmes de couplage parasite, il est important que ces bornes 104 ne soient pas trop proches des bornes d'alimentation 103. Ainsi, selon un mode de réalisation, les bornes 104 ne sont pas placées directement à côté des bornes d'alimentation 103 mais sont placées en périphérie des bornes de référence 102. Dit autrement, selon un mode de réalisation, la ou les bornes d'alimentation 103 sont disposées entre des bornes de référence 102 pour les éloigner des bornes 104. Selon un exemple, la ou les bornes 104 ne sont généralement pas disposées au-dessus du plan de masse 101. Selon un exemple, les bornes 104 peuvent être des bornes d'émission et/ou de réception de signaux radiofréquences, et/ou des bornes d'entrée/sortie (IO) du dispositif ou de la puce électronique.

Selon un exemple, la ou les bornes 105 sont des bornes adaptées à recevoir et/ou à fournir des signaux de commande qui ne sont pas des signaux radiofréquence. Selon un mode de réalisation, ces signaux sont par exemple basés sur des tensions continues. Pour éviter des problèmes de couplage parasite, il est important que ces bornes 105 ne soient pas trop proches des bornes d'alimentation 103. Ainsi, selon un mode de réalisation, les bornes 105 ne sont pas placées directement à côté des bornes d'alimentation 103 mais sont placées en périphérie des bornes de référence 102. Selon un exemple, la ou les bornes 105 ne sont généralement pas disposées au-dessus du plan de masse 101.

Selon un exemple, une ou plusieurs bornes 104 et/ou 105 peuvent être reliées directement à une borne d'alimentation 103 par l'intermédiaire d'une interconnexion 106 dédiée du boitier 100.

Ainsi, un aspect du mode de réalisation du boitier 100 est de disposer les bornes d'alimentation 103 à l'intérieur du plan de masse 101, et non en périphérie de celui-ci, pour améliorer l'encombrement du boitier, et, par exemple, pour les éloigner des bornes 104 et 105. Cela permet de réduire la taille des boitiers et, le cas échéant d'éviter des problèmes de couplage.

La présente description concerne en outre une puce électronique ou un dispositif électronique équipé d'un boitier du type du boitier 100 et comprenant au moins un composant électronique. De plus, elle concerne également un procédé de fabrication d'un tel boitier et d'une puce électronique ou d'un dispositif électronique équipé d'un tel boitier.

La figure 2 représente une vue en coupe d'une partie d'un mode de réalisation d'un boitier 200 du type du boitier 100 décrit en relation avec la figure 1.

Le boitier 200 est formé par un empilement de couches formant des niveaux de métallisations et les bornes de connexion du boitier 200. Le boitier 200 repose sur une carte de circuit imprimé 204 comprenant elle-même des niveaux de métallisations.

Plus particulièrement, selon un exemple, le boitier 200 comprend des plots de connexion 201 formant les bornes de connexion. Selon un exemple, les plots de connexion 201 sont formés par des métaux supérieur dans un substrat en silicium. Ces plots de connexion 201 reposent, par exemple, sur un niveau 202 de couche de boitier. Ce niveau 202 est formé par exemple par une couche de redistribution 202A reposant sur et en contact avec une couche 202B de métallisation de billes de connexion. Selon un exemple, les plots 201 repose directement en contact sur la couche 202A.

Selon un exemple, le niveau 202 est connecté, par des billes de connexion 203, à des niveaux de métallisation 204 du boitier. Ces billes de connexions 203 sont toutes en contact avec des portions de couche 202B, et avec une piste métallique faisant partie des niveaux de métallisation 204.

Selon un exemple, la carte de circuit imprimé 204 comprend trois niveaux 204A, 204B et 204C. Selon un exemple, les billes de connexion 203 sont en contact avec des pistes conductrices du niveau 204A. Selon un exemple, le niveau 204A comprend des pistes électroniques reliées au niveau 204B par l'intermédiaire d'un ou plusieurs vias 205A conducteurs électriquement. Selon un exemple, le niveau 204B forme un plan de masse du boitier 200. Selon un exemple, le niveau 204C comprend d'autres pistes conductrices du boitier 200.

Selon un mode de réalisation, si les plots de connexion 201 forment des bornes d'alimentation du type des bornes d'alimentation 103 décrites en relation avec la figure 1, les plots 201 sont directement reliés au niveau 204C par l'intermédiaire d'un via 205B traversant le niveau 204B reliant directement le niveau 204A au niveau 204C.

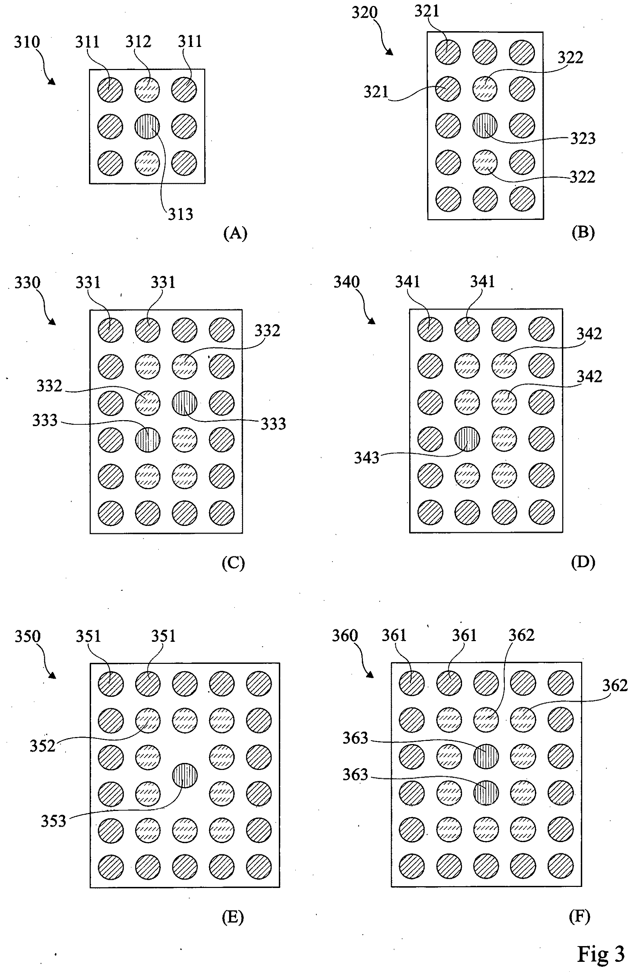

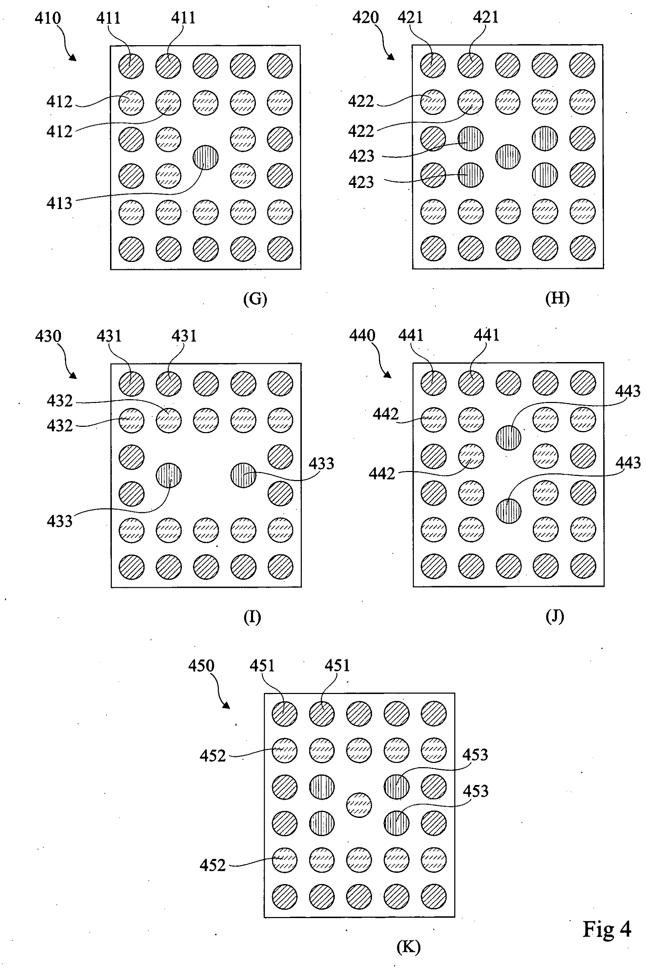

Les figures 3 et 4 comprennent des vues (A) à (K) illustrant des exemples de réalisation d'un boitier du type des boitiers 100 et 200 décrits en relation avec les figures 1 et 2.

Plus particulièrement, les vues (A) à (K) illustrant toutes des exemples de dispositions de bornes de connexion de boitier répondant aux critères décrits en relation avec la figure 1. Ainsi, chaque vue (A) à (K) représente un boitier comprenant des bornes de communication du type des bornes 104 ou 105 décrites en relation avec la figure 1, des bornes de référence du type des bornes de référence 102 décrites en relation avec la figure 1, et une ou plusieurs bornes d'alimentation du type des bornes d'alimentation 103 décrites en relation avec la figure 1.

En vue (A) est représenté un boitier 310 comprenant des bornes de communication 311, des bornes de référence 312 et une borne d'alimentation 313. Le boitier 310 présente neuf bornes de connexion disposées sous forme d'un carré de trois lignes de bornes de connexion par trois colonnes bornes de connexion. Les bornes 311 sont au nombre de six, et sont disposées sur les deux colonnes externes du carré. La borne 313 est disposée au centre du carré, et les bornes 312 sont de part et d'autre de la borne 313, verticalement dans l'orientation de la figure.

En vue (B) est représenté un boitier 320 comprenant des bornes de communication 321, des bornes de référence 322 et une borne d'alimentation 323. Le boitier 320 présente quinze bornes de connexion disposées sous forme d'un rectangle de cinq lignes de bornes de connexion par trois colonnes de bornes de connexion. Les bornes 321 sont au nombre de douze, et sont disposées sur toute la périphérie du rectangle. La borne 323 est disposée au centre du rectangle, et les bornes 322 sont de part d'autre de la borne 323, verticalement dans l'orientation de la figure, soit en colonne 2, lignes 2 et 4.

En vue (C) est représenté un boitier 330 comprenant des bornes de communication 331, des bornes de référence 332 et deux bornes d'alimentation 333. Le boitier 330 présente vingt-quatre bornes de connexion disposées sous forme d'un rectangle de six lignes de bornes de connexion par quatre colonnes de bornes de connexion. Les bornes 331 sont au nombre de seize, et sont disposées sur toute la périphérie du rectangle. Les bornes 333 sont au nombre de deux et sont disposées le plus près possible du centre du rectangle sur les deux colonnes centrales (en ligne 3, colonne 3 et en ligne 4, colonne 2). Les bornes 332 sont disposées dans les positions restantes, soit en colonne 2, lignes 2, 3 et 5 et en colonne 3, lignes 2, 4 et 5.

En vue (D) est représenté un boitier 340 comprenant des bornes de communication 341, des bornes de référence 342 et une borne d'alimentation 343. Le boitier 340 présente vingt-quatre bornes de connexion disposées sous forme d'un rectangle de six lignes de bornes de connexion par quatre colonnes de bornes de connexion. Les bornes 341 sont au nombre de seize, et sont disposées sur toute la périphérie du rectangle. La borne 343 est disposée sur l'une des quatre positions les plus près possible du centre du rectangle sur une des deux colonnes centrales (par exemple en colonne 2, ligne 4). Les bornes 342 sont disposées dans les positions restantes, autour de la bornes 343, soit en colonne 2, lignes 2, 3 et 5 et en colonne 3, lignes 2 à 5.

En vue (E) est représenté un boitier 350 comprenant des bornes de communication 351, des bornes de référence 352 et une borne d'alimentation 353. Le boitier 350 présente vingt-neuf bornes de connexion disposées sous forme d'un rectangle de six lignes de bornes de connexion par cinq colonnes de bornes de connexion, à l'exception de la colonne centrale qui ne comporte que cinq bornes de connexion. Les bornes 351 sont au nombre de dix-huit, et sont disposées sur toute la périphérie du rectangle. La borne 353 est disposée au centre du rectangle à cheval sur l'emplacement de deux bornes de connexion (à cheval sur les lignes 3 et 4). Les bornes 352 sont disposées autour de la borne 353.

En vue (F) est représenté un boitier 360 comprenant des bornes de communication 361, des bornes de référence 362 et deux bornes d'alimentation 363. Le boitier 360 présente trente bornes de connexion disposées sous forme d'un rectangle de six lignes de bornes de connexion par cinq colonnes de bornes de connexion. Les bornes 361 sont au nombre de dix-huit, et sont disposées sur toute la périphérie du rectangle. Les, bornes 363 sont au nombre de deux et sont disposées au centre du rectangle sur une même colonne (colonne 3, lignes-3 et 4). Les bornes 362 sont disposées autour des bornes 363.

En vue (G) est représenté un boitier 410 comprenant des bornes de communication 411, des bornes de référence 412 et une borne d'alimentation 413. Le boitier 410 présente vingt-neuf bornes de connexion disposées sous forme d'un rectangle de six lignes de bornes de connexion par cinq colonnes de bornes de connexion, à l'exception de la colonne centrale qui ne comporte que cinq bornes de connexion. Les bornes 411 sont au nombre de quatorze, et sont disposées sur la première ligne et la dernière ligne du rectangle, et aux extrémités des deux lignes centrales du rectangle. La borne 413 est disposée au centre du rectangle à cheval sur l'emplacement de deux bornes de connexion (à cheval sur les lignes 3 et 4). Les bornes 412 sont disposées autour de la borne 413, et sur la totalité de la deuxième ligne et de la quatrième ligne.

En vue (H) est représenté un boitier 420 comprenant des bornes de communication 421, des bornes de référence 422 et cinq bornes d'alimentation 423. Le boitier 420 présente vingt-neuf bornes de connexion disposées sous forme d'un rectangle de six lignes de bornes de connexion par cinq colonnes de bornes de connexion, à l'exception de la colonne centrale qui ne comporte que cinq bornes de connexion. Les bornes 421 sont au nombre de quatorze, et sont disposées sur la première ligne et la dernière ligne du rectangle, et aux extrémités des deux lignes centrales du rectangle. Les bornes 423 sont au nombre de cinq et sont disposées au centre du rectangle, une borne 423 étant disposée à cheval sur l'emplacement de deux bornes de connexion (à cheval sur les lignes 3 et 4). Les bornes 422 sont disposées sur la totalité de la deuxième ligne et de la quatrième ligne.

En vue (I) est représenté un boitier 430 comprenant des bornes de communication 431, des bornes de référence 432 et une borne d'alimentation 433. Le boitier 430 présente vingt-six bornes de connexion disposées sous forme d'un rectangle de cinq colonnes de bornes de connexion, la première et la dernière colonne comportant six bornes de connexion, la deuxième et quatrième colonne comportant cinq bornes de connexions et la colonne centrale comportant quatre bornes de connexion. Les bornes 431 sont au nombre de quatorze, et sont disposées sur la première ligne et la dernière ligne du rectangle, et aux extrémités des deux lignes centrales du rectangle. Les bornes 433 sont au nombre de deux et sont disposées sur un axe de symétrie horizontal du rectangle en deuxième et quatrième colonnes, chaque borne 433 étant disposée à cheval sur l'emplacement de deux bornes de connexion (à cheval sur les lignes 3 et 4). Les bornes 432 sont disposées sur la totalité de la deuxième ligne et de la quatrième ligne.

En vue (J) est représenté un boitier 440 comprenant des bornes de communication 441, des bornes de référence 442 et deux bornes d'alimentation 443. Le boitier 44 présente vingt-huit bornes de connexion disposées sous forme d'un rectangle de six lignes de bornes de connexion par cinq colonnes de bornes de connexion, à l'exception de la colonne centrale qui ne comporte que cinq bornes de connexion. Les bornes 441 sont au nombre de quatorze, et sont disposées sur la première ligne et la dernière ligne du rectangle, et aux extrémités des deux lignes centrales du rectangle. Les bornes 443 sont au nombre de deux et sont disposées sur un axe de symétrie vertical du rectangle, chaque borne 433 étant disposée à cheval sur l'emplacement de deux bornes de connexion (à cheval sur les lignes 2 et 3, respectivement 4 et 5). Les bornes 442 sont disposées de part et d'autre des bornes 443 sur la deuxième et la quatrième colonnes et aux extrémités des deuxième et quatrième lignes.

En vue (K) est représenté un boitier 450 comprenant des bornes de communication 451, des bornes de référence 452 et quatre bornes d'alimentation 453. Le boitier 450 présentent vingt-neuf bornes de connexion disposées sous forme d'un rectangle de six lignes de bornes de connexion par cinq colonnes de bornes de connexion, à l'exception de la colonne centrale qui ne comporte que cinq bornes de connexion. Les bornes 451 sont au nombre de quatorze, et sont disposées sur la première ligne et la dernière ligne du rectangle, et aux extrémités des deux lignes centrales (lignes 3 et 4) du rectangle. Les bornes 453 sont au nombre de quatre et sont disposées au centre (lignes 2 et 3) des deuxième et quatrième colonnes. Les bornes 452 sont disposées sur la totalité de la deuxième ligne et de la quatrième ligne, et au centre du rectangle à cheval sur l'emplacement de deux bornes de connexion (colonne 3, à cheval sur les lignes 3 et 4).

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Boitier (100 ; 200 ; 310 ; 320 ; 330 ; 340 ; 350 ; 360 ; 410 ; 420 ; 430 ; 440 ; 450) de puce électronique comprenant :
- au moins une première borne (103 ; 313 ; 323 ; 333 ; 343 ; 353 ; 363 ; 413 : 423 ; 433 ; 443 ; 453) adaptée à recevoir et/ou à fournir un potentiel d'alimentation ;
- au moins une deuxième borne (102 ; 312 ; 322 ; 332 ; 342 , 352 ; 362 ; 412 ; 422 ; 432 ; 442 ; 452) adaptée à recevoir et/ou à fournir un potentiel de référence ; et
- au moins une troisième borne (104 ; 311 ; 321 ; 331 ; 341 , 351 ; 361 ; 411 ; 421 ; 431 ; 441 ; 451) adaptée à recevoir et/ou à fournir un signal de données,
dans lequel ladite au moins une troisième borne est disposée en périphérie, et ladite au moins une première borne est disposée plus au centre que ladite au moins une troisième borne.

2. Procédé de fabrication d'un boitier (100 ; 200 ; 310 ; 320 ; 330 ; 340 ; 350 ; 360 ; 410 ; 420 ; 430 ; 440 ; 450) de puce électronique comprenant :
- au moins une première borne (103 ; 313 ; 323 ; 333 ; 343 ; 353 ; 363 ; 413 ; 423 ; 433 ; 443 ; 453) adaptée à recevoir et/ou à fournir un potentiel d'alimentation ;
- au moins une deuxième borne (102 ; 312 ; 322 ; 332 ; 342 ; 352 ; 362 ; 412 ; 422 ; 432 ; 442 ; 452) adaptée à recevoir et/ou à fournir un potentiel de référence ; et
- au moins une troisième borne (104 ; 311 ; 321 ; 331 ; 341 ; 351 ; 361 ; 411 ; 421 ; 431 ; 441 ; 451) adaptée à recevoir et/ou à fournir un signal de données,
dans lequel ladite au moins une troisième borne est disposée en périphérie, et ladite au moins une première borne est disposée plus au centre que ladite au moins une troisième borne.

3. Boîtier (100 ; 310 ; 320 ; 330 ; 340 ; 350 ; 360 ; 410 ; 420 ; 430 ; 440 ; 450) selon la revendication 1, ou procédé selon la revendication 2, dans lequel au moins une deuxième borne ou au moins une troisième borne est présente entre la ou chaque première borne et la périphérie du boîtier.

4. Boîtier (100 ; 320 ; 330 ; 340 ; 350 ; 360 ; 410 ; 420 ; 430 ; 440 ; 450) selon la revendication 1 ou 3, ou procédé selon la revendication 2 ou 3, dans lequel au moins une deuxième borne est présente entre une première borne et une troisième borne dans au moins une direction.

5. Boîtier selon l'une quelconque des revendications 1, 3 ou 4, ou procédé selon l'une quelconque des revendications 2 à 4, dans lequel ledit boîtier (100 ; 310 ; 320 ; 330 ; 340 ; 350 ; 360 ; 410 ; 420 ; 430 ; 440 ; 450) comporte au moins deux deuxièmes bornes, la ou chaque première borne étant disposées entre deux deuxièmes bornes dans au moins une direction.

6. Boitier selon l'une quelconque des revendication 1, 3 ou 4, ou procédé selon l'une quelconque des revendications 2 à 5, dans lequel ledit boitier (320 ; 330 ; 340 ; 350 ; 360) comprend plusieurs troisièmes bornes disposées en périphérie de la ou des deuxièmes bornes.

7. Boitier (350 ; 360 ; 410 ; 440) selon l'une quelconque des revendications 1, 3 à 6, ou procédé selon l'une quelconque des revendications 2 à 6, dans lequel la ou les premières bornes sont entourées par des deuxièmes bornes.

8. Boitier selon l'une quelconque des revendications 1, 3 à 7, ou procédé selon l'une quelconque des revendications 2 à 7, dans lequel le boitier comprend, en outre, au moins une quatrième borne (105) adaptée à recevoir et/ou à fournir un signal de commande basé sur des tensions continues.

9. Boitier selon l'une quelconque des revendications 1, 3 à 8, ou procédé selon l'une quelconque des revendications 2 à 8, dans lequel la ou au moins une des troisièmes bornes (104 ; 311 ; 321 ; 331 ; 341 ; 351 ; 361 ; 411 ; 421 ; 431 ; 441 ; 451) est adaptée à recevoir et/ou à fournir un signal radiofréquence.

10. Boitier selon l'une quelconque des revendications 1, 3 à 9, ou procédé selon l'une quelconque des revendications 2 à 9, dans lequel ledit potentiel d'alimentation est différent du potentiel de référence.

11. Boitier selon l'une quelconque des revendications 1, 3 à 10, ou procédé selon l'une quelconque des revendications 2 à 10, dans lequel ledit potentiel de référence est la masse.

12. Boitier selon l'une quelconque des revendications 1, 3 à 11, ou procédé selon l'une quelconque des revendications 2 à 11, dans lequel la ou les deuxièmes bornes (102) sont reliées à un plan de masse (101 ; 204B), et la ou les première bornes (103) sont reliées à un niveau de métallisation par un via (205B) traversant ledit plan de masse (101 ; 204B).

13. Puce électronique comprenant un boitier (100 ; 200 ; 310 ; 320 ; 330 ; 340 ; 350 ; 360 ; 410 ; 420 ; 430 ; 440 ; 450) selon l'une quelconque des revendications 1 à 12.

14. Puce selon la revendication 13 comprenant, en outre, au moins un composant électronique.

15. Procédé d'utilisation d'un boitier selon l'une quelconque des revendications 1, 3 à 14.
